# FASCICULE DE BREVET EUROPEEN

(11) **EP 2 422 365 B1**
(45) Date de publication et mention de la délivrance du brevet: **20.08.2014**
(21) Numéro de dépôt: 10725226.4
(22) Date de dépôt: 21.04.2010
(51) Int. Cl.: H01L 21/762

(54) **PROCÉDÉ DE TRANSFERT D'AU MOINS UNE COUCHE MICRO-TECHNOLOGIQUE**
MIKROTECHNOLOGIE ZUM TRANSFER MINDESTENS EINER SCHICHT
MICROTECHNOLOGY PROVEN FOR TRANSFERRING AT LEAST ONE LAYER

(30) Priorité: 22.04.2009 FR 0952621
(43) Date de publication de la demande: 29.02.2012
(73) Titulaire: Commissariat à l'Énergie Atomique et aux Énergies Alternatives, 75015 Paris (FR)
(72) Inventeur: TAUZIN, Aurélie, F-38120 Saint- Egreve (FR); STRAGIER, Anne-Sophie, F-38000 Grenoble (FR)
(74) Mandataire: Colombo, Michel
(86) Numéro de dépôt international: PCT/FR2010/050767
(87) Numéro de publication internationale: WO 2011/131847

(56) Documents cités:
- DE-C1- 10 223 719
- FR-A1- 2 940 852
- US-A1- 2005 082 526

## Description

### Etat de la technique

L'invention concerne généralement le transfert d'une couche depuis un premier substrat vers un second substrat, puis éventuellement vers un troisième substrat, etc. Diverses techniques de transfert sont connues à ce jour.

Le procédé « Eltran ® décrit un procédé de transfert de films minces basé sur la formation d'une couche fragile dans un premier substrat, des étapes technologiques appliquées à une portion superficielle de ce substrat telles que oxydation, épitaxie, réalisation de circuits..., le collage du premier substrat fragilisé, par cette portion superficielle sur un substrat support (par collage moléculaire ou anodique ou via des adhésifs) et la fracture provoquée au niveau de la couche, par exemple par l'application de contraintes mécaniques. Cette couche fragile est en principe une couche poreuse, généralement obtenue par anodisation du matériau à partir d'une face libre ; cette couche poreuse est donc typiquement située en surface au moment de sa formation. Dans la mesure où il est fréquent qu'on ait besoin, ultérieurement, que cette couche poreuse soit enterrée, à une profondeur non nulle de la surface, il est connu de recristalliser une partie de cette couche poreuse dont l'épaisseur, à partir de la surface libre, détermine la profondeur de la couche poreuse résiduelle. Toutefois, le plus souvent, on complète le substrat de départ grâce au dépôt par épitaxie d'une couche additionnelle (d'où l'intitulé du procédé, qui découle de « Epitaxial Layer Transfer ». De manière habituelle, le matériau constitutif du substrat de départ est du silicium et le second substrat est au moins en surface électriquement isolant, de sorte que, après transfert de la couche du substrat de départ qui surmonte la couche poreuse, on obtient du silicium sur isolant (« Silicium On Insulator », soit « SOI »).

Un autre procédé de transfert est connu sous la désignation de « procédé Smart Cut ® » ; il s'agit d'un procédé de transfert de films minces basé sur l'implantation d'ions gazeux, le collage du substrat implanté sur un substrat support et la réalisation éventuelle d'étapes technologiques, et enfin la fracture provoquée au niveau de la zone implantée, par exemple par un traitement thermique et/ou par application de sollicitations mécaniques.

On comprend aisément que, lors de l'élaboration de composants microtechnologiques, c'est-à-dire des composants électroniques, optiques, mécaniques, etc. dont les dimensions sont inférieures au millimètre, voire au micron, il peut être nécessaire de procéder à plusieurs transferts de manière à procéder aux étapes technologiques aux différents niveaux de profondeur nécessaires. Toutefois, pour éviter un contrôle imprécis de l'endroit où se produit la fracture, il a semblé utile jusqu'à présent de définir des étapes d'élaboration telles qu'il n'y a qu'une seule zone fragile, à un instant donné, au sein d'une structure donnée (c'est-à-dire d'un ensemble de substrats ou de couches assemblés par tout moyen approprié. On comprend néanmoins qu'une telle précaution va à l'encontre du souci de productivité qui s'impose dans le monde industriel. De l'état de la technique est également connu de DE 102 23 719 C1.

### Problème technique et présentation de l'invention

L'invention a pour objet un procédé de transfert de couches microtechnologiques permettant une plus grande vitesse de production et une plus grande souplesse dans le choix des étapes technologiques à réaliser.

L'invention propose à cet effet un procédé de transfert d'au moins une couche conforme à la revendication 1.

L'invention propose ainsi un procédé de réalisation d'une structure démontable comportant, à un moment donné, deux zones fragiles enterrées, qui permettent un double transfert de couche par une séparation mécanique ou thermique contrôlée, avec la possibilité de réaliser certaines étapes technologiques entre les deux séparations. Il est à noter que ces deux zones enterrées sont formées successivement au sein d'un même ensemble ; il ne s'agit pas seulement d'un collage de deux substrats dont chacun a préalablement fait l'objet d'un traitement de fragilisation, indépendamment du traitement de fragilisation de l'autre.

On notera que l'invention permet un bon contrôle du lieu de la fracture par la réalisation, dans un ordre approprié, dé zones fragiles ayant des caractéristiques suffisamment différentes pour que, par application de sollicitations différenciées, on puisse garantir que les fractures de ces zones fragiles se produisent dans un ordre bien déterminé compatible avec une bonne efficacité du procédé d'élaboration.

Selon des caractéristiques avantageuses de l'invention, éventuellement combinées :
- la zone fragilisée par implantation est à une distance de la surface utile du premier substrat qui est supérieure à la distance entre cette zone fragilisée et la couche poreuse, par exemple de plus du double ; un rapport inverse est possible ; cela permet de former à la fois une couche mince et une couche épaisse (au sens de la micro-technologie),

- l'on prépare le premier substrat par anodisation d'un substrat de départ en sorte de le rendre poreux en surface puis par croissance épitaxiale d'une couche dense à partir de cette couche poreuse,
- la couche poreuse est formée d'au moins deux sous-couches poreuses ayant des porosités différentes,
- la sous-couche poreuse de moindre porosité est plus proche de la surface libre que l'autre,
- la couche poreuse a une épaisseur d'au moins un micron, ce qui permet une bonne localisation de l'énergie mécanique au moment du détachement,
- la couche séparant la couche poreuse de la surface libre est en matériau monocristallin ; il s'agit par exemple de silicium, ou de germanium (ou d'un alliage Si-Ge), ou encore en AsGa, ou autres matériaux de la micro-technologie,
- la couche séparant la couche poreuse de la surface libre a une épaisseur au moins égale à 2 microns, ce qui contribue à obtenir, après le deuxième détachement (au niveau de la zone fragilisée) deux couches utiles,
- l'on forme la zone fragilisée par implantation d'au moins une espèce gazeuse (en fait d'autres options sont possibles, avec notamment une implantation d'espèces provoquant la formation de précipités pouvant être rendus liquides, lorsque le détachement est souhaité),
- l'on implante au moins de l'hydrogène ; en variante, ou en outre, l'on implante au moins de l'hélium,
- l'on provoque le détachement au niveau de la couche poreuse par application localisée d'énergie mécanique,
- les étapes technologiques comportent la formation d'au moins une partie d'un composant micro-technologique ; il s'agit par exemple d'étapes de dépôt à basse température, de découpe pour délimiter par exemple des vignettes, de sérigraphie .... et plus généralement d'étapes technologiques engendrant de fortes contraintes mécaniques mais ne nécessitant pas de budgets thermiques (température et durée) élevés.
- l'on provoque le détachement au niveau de la zone fragile par application d'un traitement thermique combiné, ou non, avec une application d'énergie mécanique,
- l'on utilise le reliquat du premier substrat comme premier substrat lors d'un nouveau cycle de mise en oeuvre du procédé,
- l'on applique en outre des étapes technologiques à chacune des parties de la couche détachée qui sont séparées lors du détachement au niveau de la zone fragilisée ; cela permet donc de poursuivre en parallèle deux processus de traitement de microstructures, d'où une productivité accrue.

Des objets, caractéristiques et avantages de l'invention ressortent de la description qui suit, donnée à titre d'exemple illustratif non limitatif, en regard des dessins annexés sur lesquels :
- La figure 1 est une vue schématique d'un substrat de départ,
- La figure 2 est une vue schématique de ce substrat après formation d'une couche poreuse par anodisation,
- La figure 3 en est une vue schématique après dépôt d'une couche superficielle,
- La figure 4 en est une vue schématique après fragilisation par implantation ionique,
- La figure 5 en est une vue schématique après assemblage à un substrat intermédiaire, par collage moléculaire,
- La figure 6 est une vue schématique de la partie supérieure de l'ensemble de la figure 5, après séparation le long de la couche poreuse,
- La figure 7 en est une vue schématique après formation de composants sur la face mise à nu par la séparation le long de la couche poreuse,
- La figure 8 en est une vue schématique après assemblage à un substrat final, le long de la face mise à nu, et
- La figure 9 est une vue schématique de l'ensemble formé à la figure 8, après séparation le long de la couche fragilisée.

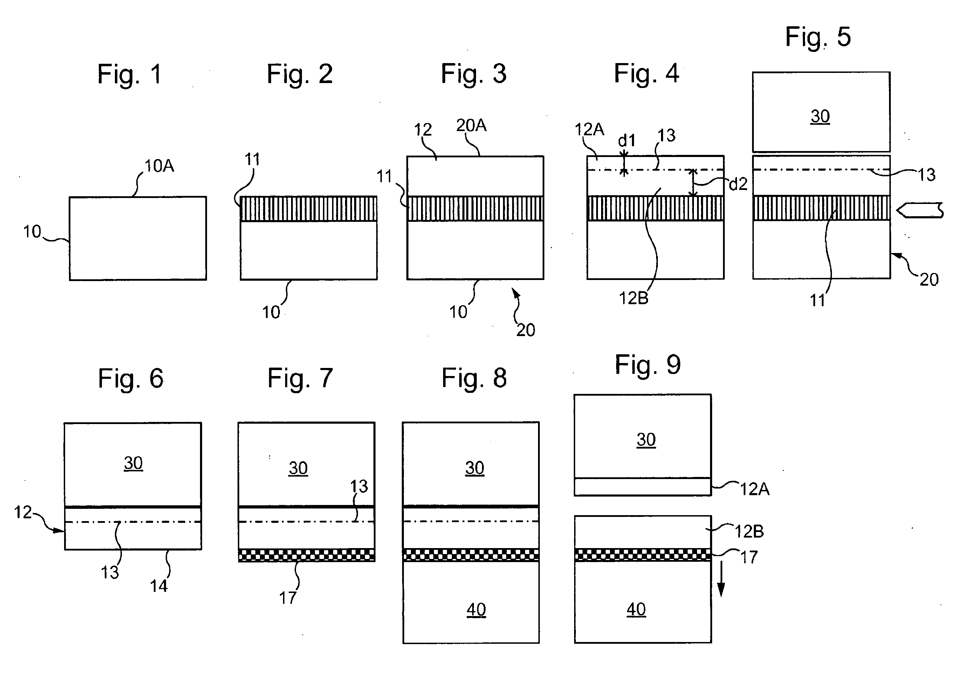

Les figures 1 à 9 représentent de manière schématique le procédé de l'invention.

On commence (voir la figure 1) par préparer, de toute manière appropriée, un substrat de départ 10, ayant une face utile 10A. Ce substrat peut être massif ou être formé d'un support sur lequel est formé une couche de travail. En fait, dans la suite, seule la partie supérieure du substrat 10 est sollicitée par le procédé.

On forme ensuite (voir la figure 2), sous la face utile 10A, une couche poreuse 11. Cette couche 11 est typiquement formée par anodisation de la partie superficielle du substrat 10 ; en variante, elle peut être formée par dépôt, par évaporation par exemple, d'une couche additionnelle, directement poreuse ou rendue au moins partiellement poreuse par un traitement adapté. Une telle couche poreuse peut ainsi être formée par compactage de poudres métalliques ou par dépôt contrôlé de silicium poreux selon la technique décrite dans l'article « Microfabrication Using One-Step LPCVD Porous Polysilicon films » de Dougherty et al - Journal of Microelectromechanical systems, Vol 12, n° 4, August 2003 pp 418-424.

Selon encore une autre variante non représentée, la couche poreuse est elle-même formée de plusieurs couches ayant des porosités différentes.

Le matériau d'au moins la portion destinée à former la couche poreuse est avantageusement en silicium, puisque c'est un matériau dont on connaît bien les conditions de traitement à appliquer pour y générer une porosité donnée ; toutefois, en variante, le matériau constitutif de cette portion peut être :
- plus généralement un matériau semi-conducteur (InP, GaAs, Ge,...) ; en effet, les semi-conducteurs peuvent être rendus poreux par anodisation,
- un métal (Aluminium, cuivre, acier, nickel, titane...) déposé par pulvérisation (« spray ») ou par compactage d'une poudre de ces métaux,
- un oxyde, par exemple un verre par rotation, parfois appelé « SOG » (spin on glass) en abrégé (il s'agit d'une technique de réalisation notamment décrite dans le document US6919106) ou un oxyde obtenu par le dépôt et l'oxydation d'une couche métallique.

Sur cette couche poreuse, on réalise ensuite (voir la figure 3) une couche superficielle 12.

On a ainsi préparé un premier substrat multicouche, noté 20 dans son ensemble, comportant une couche poreuse enterrée à une distance non nulle sous une surface libre 20A.

Cette couche est avantageusement formée par croissance épitaxiale suivant les caractéristiques cristallographiques du matériau constitutif de la couche poreuse, de sorte que cette couche 12 a une densité très supérieure à celle de la couche poreuse, en pratique voisine de 100%, similaire à celle de la partie du substrat située sous la couche poreuse. En variante, cette couche 12 peut être constituée d'une portion superficielle de la couche poreuse qui est recristallisée. En variante cette couche 12 peut être réalisée par dépôt d'un matériau polycristallin (par exemple de silicium) et cristallisation de cette couche par un recuit approprié.

Cette couche superficielle, située entre la couche poreuse et la surface libre du substrat de la figure 3, est ici homogène en étant formée d'une seule couche ; en variante, cette couche peut être formée de plusieurs sous-couches, dont notamment une couche d'oxyde thermique (constituant la surface libre), ou une couche d'accrochage pour la suite du procédé.

Ce premier substrat 20 est ensuite soumis à une implantation ionique (voir la figure 4) en sorte de fragiliser la couche superficielle 12 en une zone 13 située à une profondeur donnée, notée d1 ; cette implantation, et la fragilisation qui en découle, est donc effectuée au-dessus du niveau de la couche poreuse, à une distance non nulle de celle-ci, notée d2. Les proportions relatives entre ces distances d1 et d2 peuvent être choisies en fonction des besoins. L'épaisseur d1 de la partie supérieure 12A de la couche 12 située au-dessus de la zone fragilisée 13 est ici sensiblement supérieure à celle d2 de la partie inférieure 12B située sous cette zone fragilisée 13 mais au-dessus de la couche poreuse 11 ; on peut donc dire que, dans l'exemple considéré, la zone fragile délimite au sein de la couche 12 une couche mince 12A et une couche épaisse 12B.

L'implantation effectuée pour la formation de la zone fragilisée 13 est en pratique réalisée avec de l'hydrogène, ou une autre espèce gazeuse, notamment parmi les gaz rares, ou une combinaison de tels espèces ; il s'agit avantageusement d'une co-implantation d'hydrogène et d'hélium.

De manière préférée, la couche superficielle 12 a une épaisseur globale d'au moins 2 microns, avec avantageusement une épaisseur suffisamment supérieure à cette valeur de 2 microns pour que la zone fragilisée soit elle-même à au moins 2 microns de la couche poreuse.

A ce stade, on dispose ainsi d'un premier substrat qui comporte deux zones fragiles de natures différentes, à savoir une couche fragile 11 située en profondeur, qui est poreuse, et une zone fragilisée 13 qui est plus proche de la surface, obtenue par implantation.

Il est possible, avant ou après l'étape d'implantation, de réaliser des étapes technologiques (voir ci-dessous à propos de la couche 17).

Après une éventuelle préparation de la surface libre 20A, le premier substrat 20 est ensuite assemblé à un second substrat 30, par collage (voir la figure 5) au moyen d'un apport de matière, voire par collage moléculaire de préférence. Un éventuel recuit thermique peut être appliqué à cet ensemble 20+30 pour consolider l'interface situé entre ces substrats.

On provoque alors, par application d'une contrainte mécanique, un détachement de la partie basse du substrat initial 10, vis-à-vis du reste de la structure de cette figure 5, au niveau de la couche poreuse 11. La partie restante est schématisée à la figure 6.

Si la couche poreuse 11 est en fait formée de plusieurs couches poreuses de porosités différentes, le détachement est en pratique localisé au sein de la couche poreuse ayant la plus grande porosité.

La contrainte mécanique est schématisée à la figure 5 par une pointe ; cette contrainte mécanique peut en effet être appliquée par une lame introduite agissant au niveau de la coche poreuse. En variante, le détachement de la partie basse du substrat de départ 10 peut être provoqué par l'application d'un couple à chacun des substrats 20 et 30, sous réserve que la zone fragilisée 13 soit capable d'y résister (c'est pourquoi, il peut être préférable d'appliquer la contrainte mécanique de manière localisée, par une pointe). L'énergie mécanique appliquée peut aussi être apportée par un jet à haute pression dirigé sur la tranche de la couche poreuse, ou sous la forme d'ultrasons.

La surface 14 ainsi mise à nu peut faire l'objet d'un traitement de polissage, par exemple mécano-chimique, avant de faire l'objet d'étapes technologiques, c'est-à-dire d'étapes intervenant dans la fabrication de composants micro-technologiques, tels que des composants électroniques, mécaniques. Le résultat de telles étapes est schématisé, à la figure 7, par la formation d'une couche 15 sur la surface libre 14 mise à nu en conséquence du détachement. De manière à éviter un détachement intempestif au niveau de la zone fragile 13, la réalisation de ces étapes technologiques doit être conduite à une température modérée, typiquement inférieure à 500°C ; lorsque la réalisation de ces étapes technologiques implique l'application de contraintes mécaniques, il faut également veiller à ce que ces contraintes restent insuffisantes pour provoquer un détachement au niveau de cette couche 13. En fait, la connaissance des étapes technologiques à accomplir permet à l'homme de métier d'identifier jusqu'à quel point il peut fragiliser la zone 13 sans risquer un détachement au cours de ces étapes technologiques connues à l'avance. Bien entendu, les étapes technologiques peuvent, en variante, modifier la couche 12B sous sa surface 14, sans nécessairement générer la formation d'une surépaisseur.

La surface 14, avec l'éventuelle couche 17, est ensuite accolée à une face d'un troisième substrat 40 (voir la figure 8). Cet assemblage est avantageusement réalisé par collage, par exemple par apport de matière, voire par collage moléculaire, et des traitements classiques à cet effet peuvent être appliqués pour favoriser ce collage. Un recuit thermique peut en outre être appliqué pour consolider ce collage (en particulier s'il s'agit d'un collage moléculaire).

On peut alors provoquer le détachement de la couche mince 12A vis-à-vis de la couche épaisse 12B au niveau de la zone fragilisée 13 (voir la figure 9). Ce détachement est avantageusement obtenu par l'application d'un traitement thermique, éventuellement complété par l'application d'une énergie mécanique. Ce traitement thermique est choisi à une température suffisamment basse (en pratique entre 200°C et 500°C) pour ne pas risquer de dégrader le résultat 17 des étapes technologiques ; plus la température est basse, plus il peut être utile d'ajouter de l'énergie mécanique (elle peut être non seulement appliquée de manière locale, au niveau de la zone fragilisée (comme pour le détachement au niveau de la couche poreuse), mais aussi de manière globale par application d'efforts aux substrats 30 et 40, par exemple des couples ou des efforts antagonistes de traction.

On appréciera que le procédé qui vient d'être décrit permet de produire :
- une structure (40+17+12B) comportant une couche technologique 17 qui est enterrée sous une couche épaisse 12B,
- une structure (30+12A) comportant une couche mince 12A sur un support 30.

Chacune de ces structures peut ensuite faire l'objet d'étapes technologiques ultérieures, indépendantes ou non, tandis que la partie résiduelle du substrat de départ 10 peut être recyclée pour un nouveau cycle tel que décrit ci-dessus. Bien entendu, si l'épaisseur de la couche 12B le permet, on peut prévoir d'utiliser la structure 40+17+12B comme substrat de départ à la place du substrat 10 pour un nouveau cycle analogue à celui qui vient d'être décrit.

Ce procédé permet de manipuler des couches 12 relativement épaisses (>2µm), homogènes et de bonne qualité. Il permet de réaliser des étapes technologiques sur les deux faces de la couche active ainsi réalisée, en proposant deux modes de rupture bien distincts (mécanique ou thermique). Les étapes technologiques peuvent alors être appliquées à l'étape de la figure 7 ou après l'étape de la figure 9, en fonction des contraintes thermiques ou mécaniques qu'elles induisent.

Selon ce procédé, le second substrat 30 sert de support et doit permettre un effet de raidisseur vis-à-vis de la couche 12A pour propager une ligne de fracture au niveau de la zone implantée sans formation de cloques sur la surface implantée. En fait, si cette couche 12A a une épaisseur suffisante pour être auto-porteuse, ce second substrat peut être omis.

On comprend que les substrats 30 et 40 doivent pouvoir supporter un traitement thermique dans la gamme des 200-500°C.

De manière avantageuse, l'étape de détachement de la figure 5 peut comporter, en plus de l'application de contraintes mécaniques, une gravure chimique sélective de la couche poreuse.

Comme indiqué ci-dessus, l'étape de détachement de la figure 9 peut consister en un traitement thermique seul ou en combinaison avec l'application de contraintes mécaniques.

On comprend en effet que la différence de nature des couches fragiles 11 et 13 permet un déclenchement bien contrôlé d'un détachement au sein de chacune d'entre elles, par un choix approprié de formes d'énergie.

A titre d'exemple, si les étapes technologiques de la figure 17 comportent la formation d'une couche isolante tandis que la couche épitaxiée 12 est en silicium monocristallin, le détachement de la figure 9 conduit à l'obtention d'une structure de type « SOI » (Silicon On Insulator) 40+17+12B ainsi qu'à un transfert d'une couche mince 12A depuis le substrat de départ 10 vers le substrat 20.

### Exemple 1

Le substrat de départ est un substrat Si (100) dopé p+ (p=10mf2/cm). Une double couche de Si poreux est formée par anodisation électrochimique, en deux étapes :

| | [HF] (%) | Densité de courant (mA/cm²) | Durée d'anodisation (sec) |
|---|---|---|---|
| Etape 1 | 25 | 5 | 60 |
| Etape 2 | 12.5 | 40 | 60 |

On obtient ainsi une couche superficielle faiblement poreuse (20% de pores) d'épaisseur 1,2µm et une couche enterrée fortement poreuse (70% de pores) d'épaisseur 600nm, située sous la couche faiblement poreuse.

Le substrat Si poreux est placé dans un bâti d'épitaxie, sous H2 à 1100°C, afin de reconstruire la surface de la couche faiblement poreuse. La croissance d'une couche de Si monocristalline peut alors être réalisée à partir de la surface reconstruite, par exemple à 1100°C sous dichlorosilane. Les paramètres d'épitaxie (débit de gaz, durée) sont choisis pour que l'épaisseur de la couche épitaxiée soit de 15µm.

La couche épitaxiale est implantée avec des ions H+ dans les conditions suivantes : énergie 15keV, dose 5E16/cm². Avantageusement, l'implantation est réalisée par immersion dans un plasma d'hydrogène.

La plaque poreuse implantée est collée sur un support temporaire, qui peut être une plaque de Si, via une colle bas coût (céramique, pâte métallique, polymère haute température,...). La fracture est provoquée au niveau de la couche fortement poreuse, par l'application d'ultra-sons dans la gamme 15-400kHz, 200-6000W. La couche épitaxiée implantée est ainsi reportée sur le support temporaire. Il est possible de réaliser des étapes technologiques de fabrication de cellules solaires, comme par exemple une métallisation par sérigraphie (impliquant de fortes contraintes mécaniques). La surface processée est ensuite collée sur un support final bas coût (céramique, plastique haute température, acier,...) via une colle bas coût, et la fracture est provoquée au niveau de la zone implantée par un recuit à 800°C. La couche active ainsi reportée peut alors être processée, par exemple on peut effectuer une texturation de surface et déposer une couche anti-réflexion, de manière à réaliser une cellule solaire. Le substrat initial et le support temporaire peuvent être recyclés.

### Exemple 2

Le substrat de départ est un substrat Si (100) dopé p+ (p=10mΩ/cm). Une couche de Si poreux est formée par anodisation électrochimique selon le protocole suivant :

| [HF] (%) | Densité de courant (mA/cm²) | Durée d'anodisation (sec) |
|---|---|---|
| 25 | 30 | 85 |

On obtient ainsi une couche moyennement poreuse (40% de pores) d'épaisseur 3µm. Le substrat Si poreux est placé dans un bâti d'épitaxie, sous H₂ à 1100°C, afin de reconstruire la surface de la couche faiblement poreuse. La croissance d'une couche de Si monocristalline peut alors être réalisée à partir de la surface reconstruite, par exemple à 1100°C sous dichlorosilane. L'épaisseur de la couche Si épitaxiée est choisie de l'ordre de 3µm. La couche épitaxiale est implantée avec des ions H⁺ dans les conditions suivantes : énergie 150keV, dose 5^{E}16/cm². La plaque poreuse implantée est collée sur une plaque Si couverte d'un oxyde thermique, par adhésion moléculaire. La fracture est provoquée au niveau de la couche fortement poreuse, par l'insertion d'une lame à l'interface de collage. La couche épitaxiée implantée est ainsi reportée sur la plaque si oxydée. Il est possible de réaliser des étapes technologiques impliquant de fortes contraintes mécaniques (gravure, dépôts, ...). La surface processée est ensuite collée sur un support final qui peut être une plaque Si, par collage moléculaire via un oxyde planarisé. La fracture est provoquée au niveau de la zone implantée par un recuit à 500°C. La couche épitaxiée est alors séparée en deux couches d'épaisseur ∼1,5µm : on obtient d'une part une couche processée reportée sur un substrat Si, et d'autre part un substrat SOI classique. Chaque couche reportée peut alors être processée, par exemple on peut réaliser des étapes classiques de fabrication de composants microélectroniques (dopage, dépôts,...). Le substrat initial peut être recyclé.

On appréciera que, en enseignant d'implanter directement dans le substrat contenant la couche poreuse, l'invention permet de manipuler une couche homogène et relativement épaisse et de réaliser des étapes technologiques sur les deux faces de cette couche. La couche active est définie entre la couche poreuse et la couche implantée, ce qui laisse une grande latitude sur l'épaisseur de cette couche ; cette épaisseur peut facilement être supérieure au micron, voire à 10 microns, voire plus (et ce sans avoir recours à des énergies d'implantation très élevées, ce qui pourrait se révéler onéreux).

## Revendications

1. Procédé de transfert d'au moins une couche micro-technologique comportant des étapes selon lesquelles :
- on prépare un premier substrat (20) comportant une couche poreuse (11) enterrée sous une surface utile (20A) à une distance non nulle, ce premier substrat étant préparé en formant en surface d'un substrat de départ (10) la couche poreuse (11) puis en réalisant sur cette couche poreuse (11) une couche superficielle (12),
- on forme, par implantation d'ions dans la couche superficielle (12) du premier substrat, une zone fragilisée (13) entre cette couche poreuse et cette surface utile,
- on colle le premier substrat sur un substrat support (30),
- on provoque un détachement au niveau de la couche poreuse (11), par application d'une sollicitation mécanique, en sorte d'obtenir, d'une part, un reliquat du premier substrat et, d'autre part, une couche détachée (12) solidaire du substrat support et comportant une surface mise à nu (14),
- on effectue des étapes technologiques (17) à la surface mise à nu (14) de la couche détachée,
- on colle la couche détachée, par la surface à laquelle des étapes technologiques ont été appliquées, à un second substrat support (40),
- on provoque un détachement au niveau de la zone fragilisée (13), par application d'un traitement thermique, en sorte d'obtenir, d'une part, un reliquat de la couche détachée qui est solidaire du second substrat support (40) et, d'autre part, un reliquat de cette couche détachée qui est solidaire du premier substrat support (30).

2. Procédé selon la revendication 1, **caractérisé en ce que** la zone fragilisée par implantation est à une distance (d1) de la surface utile du premier substrat qui est inférieure à la distance (d2) entre cette zone fragilisée et la couche poreuse.

3. Procédé selon la revendication 1 ou la revendication 2, **caractérisé en ce que** l'on prépare le premier substrat (20) par anodisation d'un substrat de départ (10) en sorte de le rendre poreux en surface puis par croissance épitaxiale d'une couche dense (12) à partir de cette couche poreuse.

4. Procédé selon l'une quelconque des revendications 1 à 3, **caractérisé en ce que** la couche poreuse est formée d'au moins deux sous-couches poreuses ayant des porosités différentes.

5. Procédé selon la revendication 4, **caractérisé en ce que** la sous-couche poreuse de moindre porosité est plus proche de la surface libre que l'autre.

6. Procédé selon l'une quelconque des revendications 1 à 5, **caractérisé en ce que** la couche poreuse (11) a une épaisseur d'au moins un micron.

7. Procédé selon l'une quelconque des revendications 1 à 6, **caractérisé en ce que** la couche (12) séparant la couche poreuse (11) de la surface libre (20A) est en matériau monocristallin.

8. Procédé selon l'une quelconque des revendications 1 à 7, **caractérisé en ce que** la couche (12) séparant la couche poreuse (11) de la surface libre (20A) a une épaisseur au moins égale à 2 microns.

9. Procédé selon l'une quelconque des revendications 1 à 8, **caractérisé en ce que** l'on forme la zone fragilisée (13) par implantation d'au moins une espèce gazeuse

10. Procédé selon la revendication 9, **caractérisé en ce que** l'on implante au moins de l'hydrogène.

11. Procédé selon la revendication 9, **caractérisé en ce que** l'on implante au moins de l'hélium.

12. Procédé selon l'une quelconque des revendications 1 à 11, **caractérisé en ce que** l'on provoque le détachement au niveau de la couche poreuse (11) par application localisée d'énergie mécanique.

13. Procédé selon l'une quelconque des revendications 1 à 12, **caractérisé en ce que** les étapes technologiques comportent la formation d'au moins une partie d'un composant micro-technologique.

14. Procédé selon l'une quelconque des revendications 1 à 13, **caractérisé en ce que** les étapes technologiques comportent la formation d'au moins une couche isolante.

15. Procédé selon l'une quelconque des revendications 1 à 14, **caractérisé en ce que** l'on provoque le détachement au niveau de la zone fragile (13) par application d'un traitement thermique combiné avec une application d'énergie mécanique.

16. Procédé selon l'une quelconque des revendications 1 à 15, **caractérisé en ce que** l'on utilise le reliquat du premier substrat comme premier substrat lors d'un nouveau cycle de mise en oeuvre du procédé.

17. Procédé selon l'une quelconque des revendications 1 à 16, **caractérisé en ce que** l'on applique en outre des étapes technologiques à chacune des parties de la couche détachée qui sont séparées lors du détachement au niveau de la zone fragilisée.

## Patentansprüche

1. Verfahren zur Übertragung wenigstens einer mikrotechnologischen Schicht, das folgende Schritte aufweist, gemäß denen:
- ein erstes Substrat (20) zubereitet wird, welches eine poröse Schicht (11) aufweist, die mit einem Abstand ungleich Null unter einer nutzbaren Schicht (20A) vergraben ist, wobei dieses erste Substrat gebildet wird, indem an der Oberfläche des Ausgangssubstrats (10) die poröse Schicht (11) und dann auf dieser porösen Schicht (11) eine Oberflächenschicht (12) gebildet wird,
- durch lonenimplantierung in der Oberflächenschicht (12) des ersten Substrats ein geschwächter Bereich (13) zwischen dieser porösen Schicht und der nutzbaren Schicht gebildet wird,
- das erste Substrat an ein Trägersubstrat (30) angehaftet wird,
- auf Höhe der porösen Schicht (11) durch Ausüben einer mechanischen Beanspruchung eine Ablösung hervorgerufen wird, um einerseits einen Rückstand des ersten Substrats und andererseits eine mit dem Trägersubstrat fest verbundene abgelöste Schicht (12) zu erhalten, die eine freigelegte Fläche (14) aufweist,
- technologische Schritte (17) an der freigelegten Fläche (14) der abgelösten Schicht durchgeführt werden,
- die abgelöste Schicht mit der Fläche, an der technologische Schritte durchgeführt wurden, an ein zweites Trägersubstrat (40) angehaftet wird,
- auf Höhe des geschwächten Bereichs (13) durch Anwendung einer Wärmebehandlung eine Ablösung hervorgerufen wird, um einerseits einen Rückstand der abgelösten Schicht zu erhalten, die mit dem zweiten Trägersubstrat (40) fest verbunden ist, und andererseits einen Rückstand derjenigen abgelösten Schicht zu erhalten, die mit dem ersten Trägersubstrat (30) fest verbunden ist.

2. Verfahren nach Anspruch 1, **dadurch gekennzeichnet, dass** der durch Implantierung geschwächte Bereich einen Abstand (d1) zur nutzbaren Fläche des ersten Substrats aufweist, der kleiner ist als der Abstand (d2) zwischen diesem geschwächten Bereich und der porösen Schicht.

3. Verfahren nach Anspruch 1 oder Anspruch 2, **dadurch gekennzeichnet, dass** das erste Substrat (20) durch Anodisieren eines Ausgangssubstrats (10) gebildet wird, um es an der Oberfläche porös zu machen, und durch ein epitaktisches Aufwachsen einer dichten Schicht (12) ausgehend von dieser porösen Schicht.

4. Verfahren nach einem der Ansprüche 1 bis 3, **dadurch gekennzeichnet, dass** die poröse Schicht aus wenigstens zwei porösen Unterschichten mit unterschiedlicher Porosität gebildet wird.

5. Verfahren nach Anspruch 4, **dadurch gekennzeichnet, dass** die poröse Unterschicht mit geringerer Porosität näher an der freien Fläche ist als die andere.

6. Verfahren nach einem der Ansprüche 1 bis 5, **dadurch gekennzeichnet, dass** die poröse Schicht (11) eine Dicke von unter einem Mikron aufweist.

7. Verfahren nach einem der Ansprüche 1 bis 6, **dadurch gekennzeichnet, dass** die Schicht (12), die die poröse Schicht (11) von der freien Fläche (20A) trennt, aus monokristallinem Material besteht.

8. Verfahren nach einem der Ansprüche 1 bis 7, **dadurch gekennzeichnet, dass** die Schicht (12), die die poröse Schicht (11) von der freien Fläche (20A) trennt, eine Dicke von wenigstens gleich 2 Mikron aufweist.

9. Verfahren nach einem der Ansprüche 1 bis 8, **dadurch gekennzeichnet, dass** der geschwächte Bereich (13) durch Implantierung wenigstens einer gasförmigen Art gebildet wird.

10. Verfahren nach Anspruch 9, **dadurch gekennzeichnet, dass** wenigstens Wasserstoff implantiert wird.

11. Verfahren nach Anspruch 9, **dadurch gekennzeichnet, dass** wenigstens Helium implantiert wird.

12. Verfahren nach einem der Ansprüche 1 bis 11, **dadurch gekennzeichnet, dass** die Ablösung auf Höhe der porösen Schicht (11) durch die lokale Anwendung mechanischer Energie hervorgerufen wird.

13. Verfahren nach einem der Ansprüche 1 bis 12, **dadurch gekennzeichnet, dass** die technologischen Schritte die Bildung wenigstens eines Teils einer mikrotechnologischen Komponente umfassen.

14. Verfahren nach einem der Ansprüche 1 bis 13, **dadurch gekennzeichnet, dass** die technologischen Schritte die Bildung wenigstens einer Isolierschicht umfassen.

15. Verfahren nach einem der Ansprüche 1 bis 14, **dadurch gekennzeichnet, dass** die Ablösung auf Höhe des geschwächten Bereichs (13) durch Anwendung einer Wärmebehandlung in Kombination mit der Anwendung mechanischer Energie hervorgerufen wird.

16. Verfahren nach einem der Ansprüche 1 bis 15, **dadurch gekennzeichnet, dass** in einem neuen Ausführungszyklus des Verfahrens der Rückstand des ersten Substrats als erstes Substrat verwendet wird.

17. Verfahren nach einem der Ansprüche 1 bis 16, **dadurch gekennzeichnet, dass** ferner technologische Schritte auf jeden der Teile der abgelösten Schicht angewendet werden, die während der Ablösung auf Höhe des geschwächten Bereichs abgetrennt werden.

## Claims

1. A method for transferring at least one micro-technological layer comprising phases according to which:
- a first substrate (20) is prepared, comprising a porous layer (11) embedded under a working surface (20A) at a non-zero distance, this first substrate being prepared by forming the porous layer (11) on the surface of an initial substrate (10) and then making a surface layer (12) on this porous layer (11);
- through the implantation of ions in the surface layer (12) of the first substrate, an embrittled area (13) is formed between this porous layer and this working surface;
- the first substrate is bonded onto a supporting substrate (30);
- a detachment is caused at the level of the porous level (11), through the application of mechanical stress, in order to obtain, firstly, a remnant of the first substrate and, secondly, a detached layer (12) interlinked to the supporting substrate and including an exposed surface (14);
- technological steps (17) are applied to the exposed surface (14) of the detached layer;
- the detached layer is bonded to a second supporting substrate (40), via the surface to which technological steps have been applied;
- a detachment is caused at the level of the embrittled area (13), through the application of a heat treatment, so as to obtain, firstly, a remnant of the detached layer that is interlinked to the second supporting substrate (40) and, secondly, a remnant of that detached layer that is interlinked to the first supporting substrate (30).

2. A method according to claim 1 **characterised in that** the area embrittled by implantation is at a distance (d1) from the working surface of the first substrate that is less than the distance (d2) between that embrittled area and the porous layer.

3. A method according to claim 1 or claim 2 **characterised in that** the first substrate (20) is prepared by anodizing an initial substrate (10) so as to render its surface porous and then through the epitaxial growth of a dense layer (12) from this porous layer.

4. A method according to any of claims 1 to 3 **characterised in that** the porous layer is formed of at least two porous sub-layers having different levels of porosity.

5. A method according to claim 4 **characterised in that** the porous sub-layer that has less porosity is closer to the free surface than the other.

6. A method according to any of claims 1 to 5 **characterised in that** the porous layer (11) has a thickness of at least one micron.

7. A method according to any of claims 1 to 6 **characterised in that** the layer (12) separating the porous layer (11) from the free surface (20A) is made of a monocrystalline material.

8. A method according to any of claims 1 to 7 **characterised in that** the layer (12) separating the porous layer (11) from the free surface (20A) has a thickness at least equal to 2 microns.

9. A method according to any of claims 1 to 8, **characterised in that** the embrittled area (13) is formed by the implantation of at least one type of gas

10. A method according to claim 9, **characterised in that** at least some hydrogen is implanted.

11. A method according to claim 9, **characterised in that** at least some helium is implanted.

12. A method according to any of claims 1 to 11 **characterised in that** the detachment at the level of the porous layer (11) is caused by the localised application of mechanical energy.

13. A method according to any of claims 1 to 12 **characterised in that** the technological steps include the formation of at least one part of a micro-technological component.

14. A method according to any of claims 1 to 13 **characterised in that** the technological steps include the formation of at least one insulating layer.

15. A method according to any of claims 1 to 14 **characterised in that** the detachment at the level of the embrittled area (13) is caused by the application of a heat treatment combined with an application of mechanical energy.

16. A method according to any of claims 1 to 15 **characterised in that** the remnant of the first substrate is used as the first substrate during a further cycle for implementation of the method.

17. A method according to any of claims 1 to 16 **characterised in that** technological steps are also applied to each of the parts of the detached layer that are separated during detachment at the level of the embrittled area.
